# EUROPÄISCHE PATENTSCHRIFT

(11) **EP 2 941 861 B1**
(45) Veröffentlichungstag und Bekanntmachung des Hinweises auf die Patenterteilung: **28.02.2018**
(21) Anmeldenummer: 14747291.4
(22) Anmeldetag: 04.07.2014
(51) Int. Cl.: H04M 1/02, H04R 9/02, H01Q 1/24, H01Q 7/00

(54) **GEHÄUSEWAND**
HOUSING WALL
PAROI DE BOÎTIER

(30) Priorität: 24.07.2013 AT 504672013
(43) Veröffentlichungstag der Anmeldung: 11.11.2015
(73) Patentinhaber: Seibersdorf Labor GmbH, 2444 Seibersdorf (AT); AIT Austrian Institute of Technology GmbH, 1220 Wien (AT)
(72) Erfinder: ETTEL, Walter, A-2521 Trumau (AT); BAMMER, Manfred, A-1220 Wien (AT); SCHMID, Gernot, A-2833 Bromberg (AT)
(74) Vertreter: Wildhack & Jellinek
(86) Internationale Anmeldenummer: PCT/AT2014/050154
(87) Internationale Veröffentlichungsnummer: WO 2015/010147

(56) Entgegenhaltungen:
- EP-A1- 1 027 818
- US-A1- 2009 278 757
- US-A1- 2012 268 343
- US-A1- 2012 276 854

## Beschreibung

Die Erfindung betrifft eine Gehäusewand für ein Datenkommunikationsgerät sowie ein Gehäuse für ein Datenkommunikationsgerät sowie ein mit einem Gehäuse ausgestattetes Datenkommunikationsgerät gemäß dem Oberbegriff des Patentanspruchs 1, 10 und 11.

Grundsätzlich besteht bei Datenkommunikationsgeräten, wie z.B. Mobiltelefonen oder RFID-Lesegeräten, die eine drahtlose Datenübertragung basierend auf induktiver Kopplung zwischen dem Datenkommunikationsgerät und einem externen Gerät, wie z.B. einem NFC-Gerät oder einem Transponder, ermöglichen, das Problem, dass eine solche Datenübertragung mittels induktiver Kopplung nicht durch metallische bzw. elektrisch gut leitfähige Gehäuse, bzw. Objekte, bzw. Flächen hindurch funktioniert. Aus diesem Grund sind Datenkommunikationsgeräte wie beispielsweise Mobiltelefone mit metallischen Gehäusen in der Regel nicht geeignet, Datenübertragung mittels induktiver Kopplung mit einem externen Datenkommunikationsgerät durchzuführen. Grund dafür sind Gegeninduktionseffekte aufgrund von Wirbelströmen, die in den metallischen Objekten bzw. Flächen des Datenkommunikationsgerätes induziert werden. Das vom Sender erzeugte elektromagnetische Wechselfeld induziert im metallischen Gehäuse des Datenkommunikationsgeräts Wirbelströme, die ihrer Ursache entgegengerichtet sind und damit das resultierende für die Datenkommunikation notwendige Magnetfeld derart abschwächen, dass eine Datenkommunikation nicht möglich ist. Moderne Smartphones mit einer NFC-Schnittstelle haben daher im Bereich der NFC-Antenne, die sich normalerweise auf der Rückseite des Geräts befindet, ein nichtmetallisches Gehäuse bzw. eine nichtmetallische Abdeckung. Die Verwendung metallischer Gehäuse für Datenkommunikationsgeräte, insbesondere Mobiltelefone, hat jedoch gegenüber von nicht abschirmenden Kunststoffgehäusen vielerlei positive Aspekte und Vorteile, insbesondere im Hinblick auf Stabilität und Wärmeleitfähigkeit. Im Hinblick auf die auf induktiver Kopplung beruhende RFID- und NFC-Kommunikation, besteht dabei aber das Problem, dass die dafür verwendeten Magnetfelder nicht durchdringen können.

Die US 2009278757 A1 [AHN JUNG HO, et al.; 2009] zeigt ein mobiles Endgerät mit einem Metallgehäuse und einer im Inneren des Gehäuse liegenden Antennenstruktur. Die Antennenstruktur enthält eine Antenne zum Senden und zum Empfangen von hochfrequenten elektromagnetischen Wellen. Die Gehäusewand umfasst im Bereich der Antennenstruktur speziell zur Antenne ausgerichtete Schlitze , wobei die Schlitze, aufgrund ihrer speziellen Ausrichtung in Bezug auf die Antenne, bewirken, dass die von der Antenne ausgesendeten elektromagnetischen Wellen durch die Gehäusewand nach außen dringen können, und von außen elektromagnetische Wellen durch die Gehäusewand hindurch nach Innen zur Antenne dringen und damit von der Antenne empfangen werden können. Zur Realisierung dieser Eigenschaft, sind die Schlitze bezüglich Ihrer Geometrie auf die Sende- und Empfangsfrequenzen abgestimmt.

In ähnlicher Weise wird in US 2012268343 A1 [YANAGI MASAHIRO, et al.; 2012] eine Antennenvorrichtung offenbart, die ein Gehäuse aus einem leitenden Material umfasst. In der Oberfläche des Gehäuses ist ein Schlitz- oder Schlitzfeld ausgebildet. Weites ist eine Antenne im Gehäuse angeordnet. Die Längsrichtung des Schlitzes ist in einem vorbestimmten Winkel in Bezug auf die Längsrichtung der Antenne ausgerichtet.

Aus der US 2012276854 A1 [JOSHI HIMANSHU, et al.; 2012] ist eine implantierbare medizinische Vorrichtung bekannt die ein Gehäuse umfasst in der die Komponenten der Vorrichtung untergebracht sind. Im Gehäuse der Vorrichtung ist eine Schlitzantenne angeordnet, die mit einem externen Gerät durch die Aussparung hindurch zum Datenaustausch verbunden werden kann.

In der EP 1027818 A1 [BOEHNKE GERD; 2000] wird eine Vorrichtung offenbart, die eine magnetische Abdeckung aufweist, die im wesentlichen undurchlässig für statische Magnetfelder ist. Die Abdeckung wird durch eine Anzahl von Öffnungen durchdrungen. Die Öffnungen begrenzen räumlich die durch dynamische Magnetfelder eines Wandlers hervorgerufenen Wirbelströme, welche sich dadurch nicht in voller Stärke ausbilden können.

Die Aufgabe der Erfindung ist es, eine Gehäusewand für ein Datenkommunikationsgerät insbesondere ein Mobiltelefon zu schaffen, die im Wesentlichen metallisch ist und die Stabilität und Wärmeleitfähigkeit von Metall aufweist, aber gleichzeitig für auf induktiver Kopplung basierende Datenübertragung durchlässig ist.

Die Erfindung löst diese Aufgabe bei einer Gehäusewand der eingangs genannten Art mit den kennzeichnenden Merkmalen des Patentanspruchs 1.

Erfindungsgemäß ist bei einer Gehäusewand für ein Datenkommunikationsgerät mit einem metallischen und elektrisch leitfähigen Grundkörper vorgesehen, dass in einem Bereich der Gehäusewand ein Schlitzfeld mit einer Anzahl von Schlitzen vorgesehen ist, sodass die Gehäusewand im Bereich des Schlitzfelds für Magnetfelder zur induktiven Signaleinkopplung zur drahtlosen Kommunikation durchlässig ist. Hierdurch wird eine einfache Möglichkeit geschaffen, eine Datenkommunikation zwischen einer im Bereich der Gehäusewand angeordneten Antenne und einem auf der gegenüberliegenden Seite angeordneten Datenkommunikationsgerät wie beispielsweise einem Transponder zu schaffen, wobei gleichzeitig die Vorteile eines metallischen Gehäuses wie beispielsweise die hohe Stabilität oder die geringe Störanfälligkeit weiter bestehen.

Eine erhöhte mechanische Stabilität der erfindungsgemäßen Vorrichtung wird erreicht, wenn die Gehäusewand zumindest zweilagig aufgebaut ist und zumindest eine erste Lage und eine zweite Lage aufweist, die jeweils überlappende Schlitzbereiche mit Schlitzen aufweisen, wobei die Schlitze im Schlitzbereich gegeneinander versetzt angeordnet sind. Um gleichzeitig eine hohe mechanische Stabilität und eine geringe Unterdrückung des abgegebenen Magnetfelds zu erreichen, kann vorgesehen werden, dass zwischen der ersten Lage und der zweiten Lage eine Isolierschicht ausgebildet ist, die die beiden Lagen zueinander beabstandet und gegeneinander elektrisch isoliert.

Um zusätzlich einen Wasser- oder Gaseintritt bzw. -durchtritt zu vermeiden, kann vorgesehen sein, dass die Gehäusewand im Bereich des Schlitzfeldes mit elektrisch nichtleitendem Material verschlossen ist, und insbesondere eine Isolierschicht aufweist, welche die Schlitze abdeckt und verschließt, wobei insbesondere das Schlitzfeld der Gehäusewand luft- oder wasserundurchlässig ist.

Eine vorteilhafte Datenkommunikation durch die Gehäusewand hindurch wird erreicht, wenn an einer ihrer Seiten im Bereich des Schlitzfelds eine Spulenantenne angeordnet ist

Um eine Abschirmung des von einer Antenne abgegebenen Magnetfelds weiter zu verhindern, kann vorgesehen sein, dass das Schlitzfeld die Spulenantenne überragt.

Eine vorteilhafte Unterdrückung der Gegeninduktion wird erreicht, wenn die zwischen den Schlitzen ausgebildeten Stege eine Breite von höchstens 3 mm aufweisen.

Die Mechanische Stabilität kann weiter verbessert werden, indem die Schlitze der ersten Lage und die Schlitze der zweiten Lage zueinander Winkel von mehr als 45°, insbesondere von mehr als 85°, einschließen.

Die Erfindung betrifft ferner ein Gehäuse für ein Datenkommunikationsgerät umfassend eine Gehäusewand nach einem der vorangehenden Ansprüche sowie eine im Inneren des Gehäuses, im Bereich des Schlitzfelds angeordnete Spulenantenne.

Weiters betrifft die Erfindung ein Datenkommunikationsgerät, insbesondere Mobiltelefon, mit einem Gehäuse nach Anspruch 10.

Mehrere Ausführungsbeispiele der Erfindung sind anhand der folgenden Zeichnungsfiguren dargestellt.

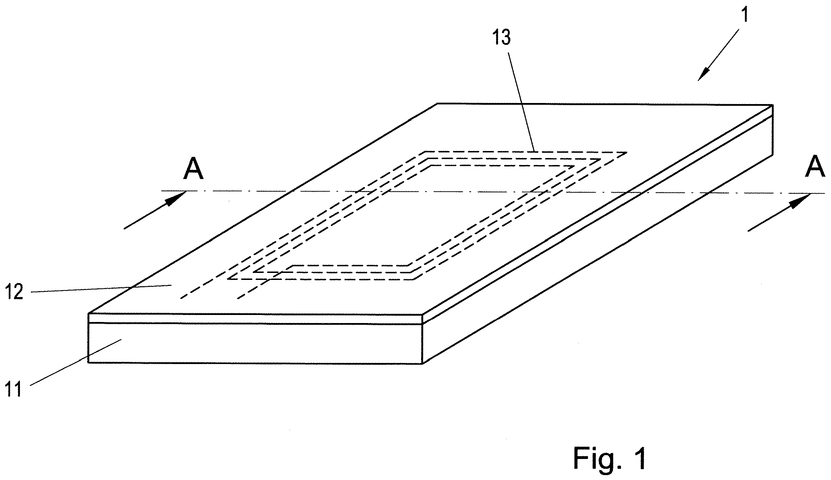

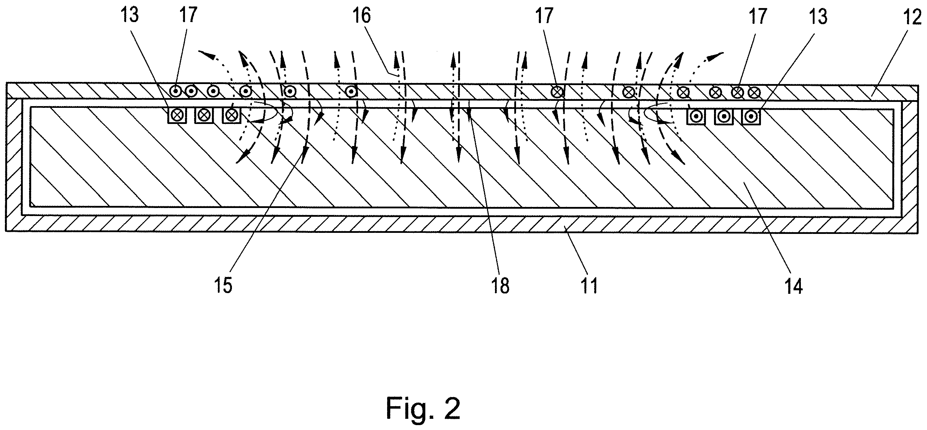

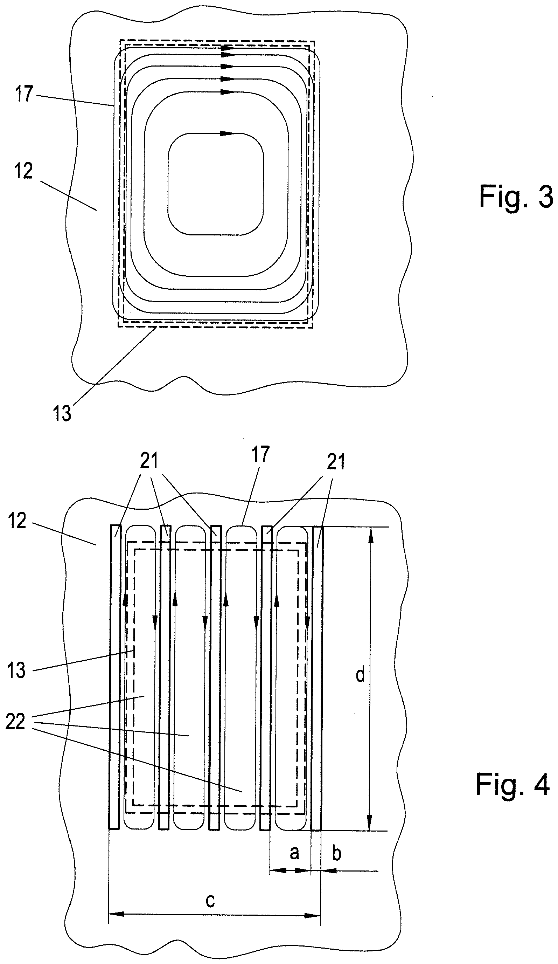

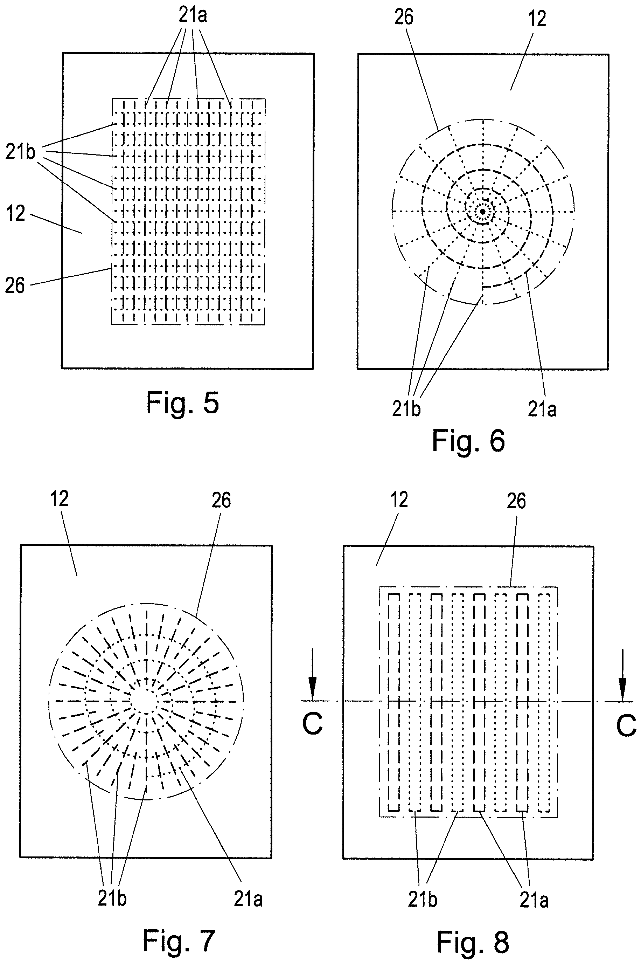

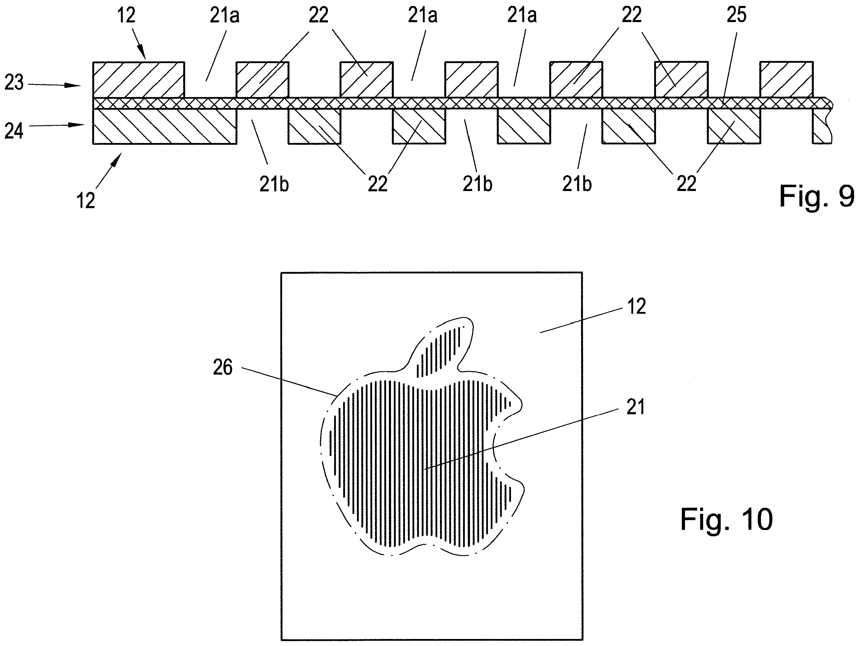

**Fig. 1** zeigt ein Mobiltelefon mit einem metallischen Gehäuse gemäß dem Stand der Technik. In **Fig. 2** ist ein Schnitt durch das in **Fig. 1** dargestellte Mobiltelefon dargestellt. **Fig. 3** zeigt die Ausbildung von Wirbelströmen in einer vollmetallischen Gehäusewand. **Fig. 4** zeigt die Ausbildung von Wirbelströmen in einer bevorzugten erfindungsgemäßen Gehäusewand. **Fig. 5 bis 7** zeigen bevorzugte zweilagige Gehäusewände. **Fig. 8** **und** **9** zeigen eine weitere zweilagige Ausführungsform einer Gehäusewand in Vorderansicht sowie im Schnitt. **Fig. 10** zeigt eine weitere vorteilhafte Ausbildung einer Gehäusewand, bei der das Schlitzfeld als Designelement verwendet wird.

**Fig. 1** zeigt ein Mobiltelefon mit einem metallischen Gehäuse gemäß dem Stand der Technik. Im vorliegenden Beispiel weist das Mobiltelefon 1 zwei Gehäuseteile 11, 12, nämlich einen wannenartigen Gehäuseteil 11 und einen flachen Gehäuseteil 12 auf, die zusammengesetzt die Elektronik 14 (**Fig. 2**) des Mobiltelefons umschließen und abschirmen.

Weiters zeigt **Fig. 1** eine NFC-Antenne 13, die mit der Elektronik 14 des Mobilfunkgeräts verbunden ist und im Inneren des durch die beiden Gehäuseteile 11, 12 gebildeten Gehäuses des Mobiltelefons 1 liegt.

Wie in **Fig. 2** dargestellt, wird durch die Antenne 13 ein elektromagnetisches Feld erzeugt. Die strichlierten Pfeile 15 stellen dasjenige elektromagnetische Feld dar, das ohne die metallische Abschirmung der Gehäusewand 12 entsteht. Die punktierten Pfeile 16 zeigen das elektromagnetische Feld, das durch Wirbelströme 17 entsteht, die in der Gehäusewand 12 induziert werden. Als Resultat der Überlagerung der beiden Magnetfelder 15, 16 ergibt sich ein resultierendes Magnetfeld 18, das gegenüber dem ursprünglichen Magnetfeld 15 stark abgeschwächt ist. Die Reichweite und Stärke des Magnetfelds bzw. der Datenübertragung, die mittels NFC ausgehend von dem Mobiltelefon 1 möglich ist, ist daher deutlich reduziert.

Um das Ziel eines für eine induktive Kommunikation ausreichenden resultierenden Magnetfeldes außerhalb des Mobiltelefongehäuses zu erreichen, kann die Ausbildung der Wirbelstrominduktion unterdrückt werden. Eine Verminderung der elektrischen Leitfähigkeit des Materials der Gerätegehäuse-Rückwand ist mit gegenwärtig technisch verfügbaren Materialien nicht möglich ohne gleichzeitig auch viele (thermische) Vorteile einer metallischen Gerätegehäuse-Rückwand zu verlieren.

In **Fig. 3** ist der Effekt der Stromverdrängung in der Gehäusewand 12 des in **Fig. 1** **und** **2** dargestellten Mobiltelefons 1 näher dargestellt. Zu beachten ist, dass die sich ausbildenden Wirbelströme zufolge des Effekts der Stromverdrängung, sich entlang des Randes der vom Magnetfeld durchsetzten Metallfläche konzentrieren.

Eine ausreichende Unterdrückung der Wirbelstrominduktion kann jedoch erreicht werden, wenn die flächige Struktur des metallischen Gehäuses 11, 12, zumindest im Bereich der induktiven Antenne 13 so gestaltet wird, dass sich Wirbelströme 17 nicht mehr oder nur mehr in sehr eingeschränktem Ausmaß darin ausbilden können. Am einfachsten ist dies durch die Ausgestaltung von Schlitzen 21 in der metallischen Gehäusewand 11 im Bereich der Antenne 13, wie in **Fig. 4** dargestellt, möglich. Diese Schlitze 21 können beliebig dünn sein, es braucht nur zu einer ausreichenden Erhöhung des ohmschen Widerstandes in Querrichtung zu den Schlitzen kommen, wie dies in **Fig. 4** schematisch dargestellt ist.

Aufgrund der Schlitze im Metall können sich die induzierten Wirbelströme 17 nicht ungehindert ausbreiten (**Fig. 3 und 4**). Natürlich kommt es in den einzelnen Stegen 22 zwischen den Schlitzen 21 zur Wirbelstrominduktion. Aufgrund der vergleichsweise geringen Stegbreite a liegen gegensinnig durchflossene Strompfade nah beieinander und kompensieren einander hinsichtlich der Gegeninduktionswirkung der Wirbelströme. Durch Auswahl einer geringen Stegbreite a wird die Gegeninduktionswirkung weiter abgeschwächt. Die Gehäusewand 12 wird umso durchlässiger für das von der Antenne 13 erzeugte Magnetfeld, je kleiner die Stegbreite a gewählt wird.

Wird jener Bereich eines metallischen Gerätegehäuses der die Spulenantenne 13 abdeckt, wie oben gezeigt mit Schlitzen 21 versehen, wird auch das von der Spulenantenne 13 erzeugte Magnetfeld nicht mehr, bzw. nur mehr geringfügig abgeschwächt, so dass eine drahtlose Kommunikation durch induktive Kopplung durch das Metallgehäuse 12 hindurch möglich ist.

Da die Schlitzbreite b sehr klein ausgeführt sein kann ohne den gewünschten Effekt zu mindern, besteht auch die Möglichkeit, beispielsweise durch Beschichtung der Gehäusewand 12 mit elektrisch nicht-elektrisch leitfähigen Materialien, eine wasserdichte, bzw. weitgehend luftdichte Abdeckung trotz der Schlitze 21 zu erzielen. Hierbei überbrückt ein auf die Gehäusewand 12 aufgebrachtes elektrisch nicht-leitfähiges Material die Schlitze 21, die jeweils nur eine sehr geringe Schlitzbreite b aufweisen.

**Fig. 5 bis 7** zeigen Beispiele von Gehäusewänden 12 mit Anordnungen zweier übereinander, jedoch elektrisch voneinander isoliert angeordneter Metallschichten, die eine Gegeninduktionswirkung ausreichend unterdrücken und damit eine induktive Kommunikation durch die Gehäusewand 12 hindurch ermöglichen.

In den **Fig. 5 bis 7** sind mehrere Ausführungsformen von Gehäusewänden 12 mit zweilagigen Schlitzfeldern dargestellt, wobei in der ersten Lage 23 (**Fig. 9**) die strichliert dargestellten Schlitze 21a und in der zweiten Lage 24 (**Fig. 9**) die punktiert dargestellten Schlitze 21b vorhanden sind.

Die durch Schlitze 21 verursachte Antennenwirkung kann insbesondere im UHF und Mikrowellenbereich auch mit zwei Lagen 23, 24 geschlitzter, gegeneinander elektrisch isolierter Metallschichten in einer Anordnung gemäß **Fig. 8** **und** **9** unterdrückt werden. **Fig. 8** zeigt eine solche Ausführungsform, wobei **Fig. 9** einen Schnitt C-C in **Fig. 8** zeigt. Hier ist eine Isolierschicht 25 dargestellt, die die beiden Lagen 23, 24 zueinander isoliert und das Eindringen von Flüssigkeiten durch die Gehäusewand 12 verhindert.

Typische Antennen 13 sind für induktive Datenübertragung im Frequenzbereich zwischen 10 kHz und 100 MHz, insbesondere 120-135 kHz, 13-14 MHz, 25-30 MHz ausgebildet.

Die Gegeninduktionswirkung wird lokal vor allem durch die Stegbreiten a bzw. Schlitzabstände beeinflusst. Je kleiner die Stegbreiten a, desto besser wird die Gegeninduktionswirkung unterdrückt. In der Praxis erscheinen Stegbreiten a mit höchstens 3 mm sinnvoll.

Für uneingeschränkten Betrieb der induktiven Datenkommunikation, wobei Kommunikation mit allen Transpondergrößen möglich ist, so wie es auch im Fall eines nicht-metallischen Gehäuses der Fall wäre, werden die Abmessungen des Schlitzfeldes 26, insbesondere die rechteckige Fläche der Größe Schlitzfeldlänge x Schlitzfeldbreite, größer als die Außenabmessungen der Spulenantenne 13 festgelegt. Das Schlitzfeld 26 überragt die Spulenantenne 13. Ist das Schlitzfeld 26 kleiner als die Außenabmessungen der Spulenantenne 13 des Mobiltelefons, so ist zumindest noch eine Kommunikation mit Transpondern möglich, deren Transponderantenne kleiner als das Schlitzfeld 26 ist.

Es ist natürlich auch möglich, das Schlitzfeld 26 so zu gestalten, dass es gleichzeitig auch Werbe- bzw. Markenidentitäts- bzw. Marketingzwecke erfüllt (**Fig. 10**).

## Patentansprüche

1. Gehäusewand (12) für ein Datenkommunikationsgerät (1) mit einem metallischen und elektrisch leitfähigen Grundkörper,
wobei in einem Bereich der Gehäusewand (12) ein Schlitzfeld (26) mit einer Anzahl von Schlitzen (21) vorgesehen ist, sodass die Gehäusewand (12) im Bereich des Schlitzfelds (26) für Magnetfelder zur induktiven Signaleinkopplung zur drahtlosen Kommunikation durchlässig ist,
wobei die Gehäusewand zumindest zweilagig aufgebaut ist und zumindest eine erste Lage (23) und eine zweite Lage (24) aufweist bei denen jeweils innerhalb eines gemeinsamen Schlitzbereichs (26) Schlitze (21a, 21b) vorhanden sind
**dadurch gekennzeichnet,**
- **dass** im Schlitzbereich (26) die Schlitze (21a) der ersten Lage (23) zu den Schlitzen (21b) der zweiten Lage (24) versetzt angeordnet sind, und
- **dass** zwischen der ersten Lage (23) und der zweiten Lage (24) eine Isolierschicht (25) ausgebildet ist, die die beiden Lagen (23, 24) zueinander beabstandet und gegeneinander elektrisch isoliert.

2. Gehäusewand (12) nach Anspruch 1, **dadurch gekennzeichnet, dass** die Gehäusewand (12) im Bereich des Schlitzfeldes (26) mit elektrisch nichtleitendem Material verschlossen ist.

3. Gehäusewand (12) nach Anspruch 1 oder 2, **dadurch gekennzeichnet, dass** die Gehäusewand (12) eine Isolierschicht (25) aufweist, welche die Schlitze (21) abdeckt und verschließt.

4. Gehäusewand (12) Anspruch 3, **dadurch gekennzeichnet, dass** das Schlitzfeld (26) der Gehäusewand (12) luft- oder wasserundurchlässig ist.

5. Gehäusewand (12) nach einem der vorangehenden Ansprüche, **dadurch gekennzeichnet, dass** an einer ihrer Seiten im Bereich des Schlitzfelds (26) eine Spulenantenne (13) angeordnet ist.

6. Gehäusewand (12) nach einem der vorangehenden Ansprüche, **dadurch gekennzeichnet, dass** das Schlitzfeld (26) die Spulenantenne (13) überragt.

7. Gehäusewand (12) nach einem der vorangehenden Ansprüche, **dadurch gekennzeichnet, dass** die zwischen den Schlitzen (21) ausgebildeten Stege (22) eine Breite von höchstens 3 mm aufweisen.

8. Gehäusewand (12) nach einem der vorangehenden Ansprüche, **dadurch gekennzeichnet, dass** die Schlitze (21a) der ersten Lage (23) und die Schlitze (21b) der zweiten Lage (21b) zueinander Winkel von mehr als 45° einschließen.

9. Gehäusewand (12) nach einem der vorangehenden Ansprüche, **dadurch gekennzeichnet, dass** die Schlitze (21a) der ersten Lage (23) und die Schlitze (21b) der zweiten Lage (21b) zueinander Winkel von mehr als 85° einschließen.

10. Gehäuse (11, 12) für ein Datenkommunikationsgerät (1) umfassend eine Gehäusewand (12) nach einem der vorangehenden Ansprüche sowie eine im Inneren des Gehäuses (11, 12) angeordnete, im Bereich des Schlitzfelds (26) angeordnete Spulenantenne (13).

11. Datenkommunikationsgerät, insbesondere Mobiltelefon (1), mit einem Gehäuse (11, 12) nach Anspruch 10.

## Claims

1. A housing wall (12) for a data communication device (1) having a metallic and electrically conductive base body,
wherein in a region of the housing wall (12) a slotted area (26) having a plurality of slots (21) is provided so that the housing wall (12) in the region of the slotted area (26) is permeable to magnetic fields for inductive signal coupling for wireless communication,
wherein the housing wall has at least two layers and has at least one first layer (23) and one second layer (24) in which there are slots (21a, 21b) within a common slot region (26),
**characterised in that**
- in the slot region (26) the slots (21a) of the first layer (23) are arranged offset with respect to the slots (21b) of the second layer (24), and
- that between the first layer (23) and the second layer (24) an insulating layer (25) is formed which spaces the two layers (23, 24) with respect to one another and electrically insulates them with respect to one another.

2. The housing wall (12) according to claim 1, **characterised in that** the housing wall (12) in the region of the slotted area (26) is sealed by an electrically non-conductive material.

3. The housing wall (12) according to claim 1 or 2, **characterised in that** the housing wall (12) has an insulating layer (25) which covers and seals the slots (21).

4. The housing wall (12) according to claim 3, **characterised in that** the slotted area (26) of the housing wall (12) is air- or water-impermeable.

5. The housing wall (12) according to one of the preceding claims, **characterised in that** a coil antenna (13) is arranged on one of the sides thereof in the region of the slotted area (26).

6. The housing wall (12) according to one of the preceding claims, **characterised in that** the slotted area (26) projects beyond the coil antenna (13).

7. The housing wall (12) according to one of the preceding claims, **characterised in that** the webs (22) configured between the slots (21) have a maximum width of 3 mm.

8. The housing wall (12) according to one of the preceding claims, **characterised in that** the slots (21a) of the first layer (23) and the slots (21b) of the second layer (21b) enclose angles of more than 45° with respect to one another.

9. The housing wall (12) according to one of the preceding claims, **characterised in that** the slots (21a) of the first layer (23) and the slots (21b) of the second layer (21b) enclose angles of more than 85° with respect to each other.

10. The housing (11, 12) for a data communication device (1) comprising a housing wall (12) according to one of the preceding claims and a coil antenna (13) arranged in the interior of the housing (11, 12) and arranged in the region of the slotted area (26).

11. A data communication device, in particular mobile telephone (1), comprising a housing (11, 12) according to claim 10.

## Revendications

1. Paroi de boîtier (12) pour un appareil de communication de données (1) comprenant un corps de base métallique et électriquement conducteur,
dans lequel, dans une région de la paroi de boîtier (12), une zone à fentes (26) est prévue avec un certain nombre de fentes (21), de sorte que la paroi de boîtier (12), dans la région de la zone à fentes (26) soit perméable aux champs magnétiques pour le couplage de signal inductif servant à la communication sans fil,
dans lequel la paroi de boîtier est formée avec au moins deux couches et présente au moins une première couche (23) et une seconde couche (24) dans lesquelles des fentes (21a, 21b) sont respectivement prévues au sein d'une région à fentes (26) commune
**caractérisée en ce**
- **que**, dans la région à fentes (26), les fentes (21a) de la première couche (23) sont disposées de façon décalée par rapport aux fentes (21b) de la seconde couche (24) et
- en ce que, entre la première couche (23) et la seconde couche (24), une couche isolante (25) est formée, qui espace les deux couches (23, 24) l'une de l'autre et les isole électriquement l'une de l'autre.

2. Paroi de boîtier (12) selon la revendication 1, **caractérisée en ce que** la paroi de boîtier (12) est obturée, dans la région de la zone à fentes (26) avec un matériau électriquement non conducteur.

3. Paroi de boîtier (12) selon la revendication 1 ou 2, **caractérisée en ce que** la paroi de boîtier (12) présente une couche isolante (25), qui recouvre et obture les fentes (21).

4. Paroi de boîtier (12) selon la revendication 3, **caractérisée en ce que** la zone à fentes (26) de la paroi de boîtier (12) est imperméable à l'air ou à l'eau.

5. Paroi de boîtier (12) selon une des revendications précédentes, **caractérisée en ce qu'**une antenne bobine (13) est disposée au niveau d'un de ses côtés dans la région de la zone à fentes (26).

6. Paroi de boîtier (12) selon une des revendications précédentes, **caractérisée en ce que** la zone à fentes (26) surmonte l'antenne bobine (13).

7. Paroi de boîtier (12) selon une des revendications précédentes, **caractérisée en ce que** des passerelles (22) formées entre les fentes (21) présentent une largeur de 3 mm maximum.

8. Paroi de boîtier (12) selon une des revendications précédentes, **caractérisée en ce que** les fentes (21a) de la première couche (23) et les fentes (21b) de la seconde couche (21b) forment entre elles un angle supérieur à 45 °.

9. Paroi de boîtier (12) selon une des revendications précédentes, **caractérisée en ce que** les fentes (21a) de la première couche (23) et les fentes (21b) de la seconde couche (21b) forment entre elles un angle supérieur à 85 °.

10. Boîtier (11, 12) pour un appareil de communication de données (1) comprenant une paroi de boîtier (12) selon une des revendications précédentes, ainsi qu'une antenne bobine (13) disposée dans l'intérieur du boîtier (11, 12), dans la région de la zone à fentes (26).

11. Appareil de communication de données, en particulier téléphone mobile (1), comprenant un boîtier (11, 12) selon la revendication 10.
